# EUROPÄISCHE PATENTSCHRIFT

(11) **EP 1 162 631 B1**
(45) Veröffentlichungstag und Bekanntmachung des Hinweises auf die Patenterteilung: **26.07.2006**
(21) Anmeldenummer: 01890163.7
(22) Anmeldetag: 28.05.2001
(51) Int. Cl.: H01B 7/08

(54) **Stecker zur Kontaktierung eines Flachbandkabels**
Connector for contacting a flat ribbon-cable
Connecteur pour connecter un câble-ruban plat

(30) Priorität: 08.06.2000 EP 00890189
(43) Veröffentlichungstag der Anmeldung: 12.12.2001
(73) Patentinhaber: I & T Innovation Technology Entwicklungs- und Holding Aktiengesellschaft, 7011 Siegendorf (AT)
(72) Erfinder: Adams, Winfried, 71067 Sindelfingen (DE); Schubert, Artur, Ing., 2803 Schwarzenbach (AT)
(74) Vertreter: Wildhack, Helmut

(56) Entgegenhaltungen:
- FR-A- 2 557 385
- US-A- 3 728 661

## Beschreibung

Die Erfindung betrifft einen Stecker zur Kontaktierung eines Flachbandkabels, das voneinander elektrisch isolierte, d.h. mit Abstand zueinander angeordnete, Rechteckleiter aufweist, die von einer auflaminierten oder aufextrudierten, elektrisch isolierenden Hülle umgeben sind, wobei das Flachbandkabel in einem Bereich, der im Abstand vom Ende des Flachbandkabels liegt, mit einer zumindest einseitigen Abisolierung des Flachbandkabels versehen ist und so einen Isoliersteg an dessen Ende beläßt, dessen Erstreckung in Richtung der Leiterbahnen bevorzugt etwa 1 bis 10 mm, besonders bevorzugt 2 bis 4 mm beträgt, entsprechend dem einleitenden Teil des Anspruches 1.

Ein Flachbandkabel mit derartig ausgebildeten Enden ist aus der FR 2 557 385 A bekannt. Zur Kontaktierung wird der Isoliersteg des Flachbandkabels in eine Nut eines Steckers gesteckt und das kabel durch Schrauben, kleben etc. am Steckers befestigt. Dabei wodem der Isoliersteg und der Beginn des durchgehend isolierten Bereiches so zueinander positioniert, dass der abisolierte Bereich "gestaucht" und damit gebogen wird, nun eine Federkraft zu kontaktierung aufzubringen. Auf diesen gebogenen Abschnitt der einzelnen Rechteckleiter drücken dann Kontaktflächen des Steckers.

Laminierte elektrische Flachleiter bestehen im wesentlichen aus einer flexiblen Trägerfolie, mit einem darauf aufgebrachten, vorgeformten Leitungssatz. Der Leitungssatz besteht aus einzelnen Leiterbahnen. Die einzelnen Leiterbahnen sind voneinander elektrisch isoliert, d.h. mit Abstand zueinander angeordnet und weisen einen rechteckigen Querschnitt mit zum Teil unterschiedlichen Dimensionen auf und werden deshalb auch als Rechteckleiter bezeichnet. Die Oberseiten der Leiterbahnen sind elektrisch isoliert, wobei insbesondere Folien verwendet werden, die mit Hilfe geeigneter Klebstoffe auf die Leiter und die untere, die Trägerfolie, laminiert werden. Solche flexible Leiter, im Fachjargon FFC (Flexible Flat Cable) genannt, werden in zunehmendem Maße auch als Ersatz herkömmlicher, aus Rundleitern bestehender Kabelbäume im Kraftfahrzeugbau eingesetzt.

Eine andere Methode um extrudierte Flachkabel herzustellen, besteht darin, die Leiterbahnen durch einen Extrusionsvorgang mit einer elektrisch isolierenden Hülle zu umgeben, wobei die Form und die Eigenschaften des fertigen extrudierten Flachkabels zumindest im wesentlichen der Form und den Eigenschaften des fertigen laminierten Flachkabels entsprechen.

Gegenüber herkömmlichen Kabelbäumen ergeben sich bei der Verwendung von FFC verschiedene Vorteile: Durch die Verwendung von Rechteckleitern als Leiterbahnen können bei gleicher Querschnittfläche, verglichen mit Rundleitern, größere Strommengen übertragen werden, womit es insbesondere im Automobilbau zu einer Gewichtsreduktion und Reduktion des Bedarfes an Bauraum kommt. Auch ist die Übersichtlichkeit und insbesondere die flache Ausgestaltung eines solchen Kabelbaumes vorteilhaft, daß ein solcher Kabelbaum auch hinter Verkleidungen mit geringer Bauraumtiefe angebracht werden kann.

Nachteilig bei derartigen Flachbandkabeln (und dies bei beiden Arten) ist bisher das Problem der mechanischen Stabilität beim Transport derartiger Flachbandkabel im abisolierten Zustand, da die einzelnen Rechteckleiter keine merkliche mechanische Stabilität aufweisen und sich einer automatisierten Handhabung widersetzen und die elektrische Verbindung solcher Flachbandkabeln mit Platinen in Steuergeräten, mit anderen Flachleitern oder beim Übergang zu herkömmlichen Rundleitern. Auch dabei hat sich die mechanische Anfälligkeit der abisolierten und nicht mehr über das Laminat miteinander verbundenen Rechteckleiter als unangenehm herausgestellt. Die eingangs genannte Druckschrift löst zwar das Problem der mangelden Stabilität des Flachbandkabels, aber der beschriebene Kontaktierung des Flachbandkabels wrist nachteile auf.

Es ist die Aufgabe der vorliegenden Erfindung, einen geeigneten Stecker für ein so vorbereitetes Flachbandkabel zu schaffen, bei dem dessen Einbringen merklich erleichtert ist und bei dem zugleich auch das Problem der Zugentlastung der Leiterbahn gelöst ist.

Erfindungsgemäß wird diese Aufgabe dadurch gelöst, daß der Stecker im Bereich der Abisolierung jedes zu kontaktierenden Rechteckleiters zumindest einen Steckerkontakt aufweist und im Bereich des Isoliersteges jedes zu kontaktierenden Rechteckleiters zumindest eine bewegliche Spitze und/oder zumindest eine im wesentlichen quer zum Rechteckleiter verlaufende Schneide aufweist, die im Zuge der Kontaktierung des Flachbandkabels eine Bewegung zum Rechteckleiter hin vollführt, sodaß die Spitze und/oder Schneide den Rechteckleiter durch die auf dieser Seite abdeckende, elektrisch isolierende Schichte, Folie, oder Extrudat, hindurch mechanisch kontaktiert und plastisch deformiert.

Auf diese Weise werden die im Betrieb auftretenden Zugkräfte direkt auf die Leiterbahn übertragen und es kommt zu einer ausreichenden Zugentlastung. Durch die Verwendung der erfindungsgemäßen Stecker, die ja in der Praxis immer mehrere Rechteckleiter gemeinsam kontaktieren, wenn auch selbstverständlich elektrisch getrennt voneinander, kommt es noch zu einem Ausgleich eventueller toleranzbedingter, ungleichmäßiger Haltekräfte, da durch den am Ende des Flachbandkabels belassenen Steg der Trägerfolie und der Abdeckfolie ein solcher mechanischer Ausgleich stattfinden kann, was bei Einzelleitern unmöglich wäre.

In einer Ausgestaltung der Erfindung ist vorgesehen, daß zumindest eine Spitze bzw. Schneide vom Steckerkontakt überzogen ist. Damit erreicht man, dass auch der mechanische Kontakt zwischen Spitze bzw. Schneide und Rechteckleiter zur elektrischen Kontaktierung herangezogen wird.

Eine Weiterbildung der Erfindung sieht vor, daß der Steckerkontakt bügelartig ausgebildet und gegenüber dem Isolierbereich des Flachbandkabels im Stecker fixiert ist, sodass es beim Schließen des Steckers zu einer Bewegung der Kontaktflächen des Steckerkontaktes an der Oberfläche der Rechteckleiter kommt, sodaß eventuell an der Oberfläche des Rechteckleiters befindliche Verunreinigungen entfernt werden und die Kontaktierung verbessert wird.

Gemäß einer Variante ist vorgesehen, daß der Stecker ein Gehäuse besitzt, das seitlich Haken aufweist, die beim Einschieben des Isolierbereiches in den Stecker durch Anschläge so verdreht werden, daß die Hakenenden, in Einschubrichtung gesehen, hinter den Isolierabschnitt gelangen. Damit wird die mechanische Fixierung des FFC im Stecker erreicht und gleichzeitig die Richtigkeit der Endlage überprüft.

Eine Ausgestaltung dieser Variante sieht vor, daß Vorsprünge, Stifte, Leisten, Nocken od.dgl. vorgesehen sind, die erst mit erfolgtem vollständigem Einschwenken der Haken in eine Position gelangen, in der das Gehäuse des Steckers korrespondierende Ausnehmungen aufweist, die das Schließen gestatten. Dadurch wird sichergestellt, daß die Endlage fixiert wird und daß die optische Kontrolle des Erreichens der Endlage leicht möglich ist.

In einer weiteren Ausgestaltung der Erfindung ist vorgesehen, daß die Bauteile des Steckers, die die Spitzen bzw. die Schneiden und den Steckerkontakt tragen, an ihrem, dem Flachband zugekehrten Ende, Leisten, Rippen, Zacken oder eine quer zur Richtung der Rechteckleiter verlaufende Riffelung aufweisen, die das Flachbandkabel im Bereich jenseits der Abisolierung kontaktiert. Dadurch kann das Eindringen von Schmutz und Verunreinigungen in den Kontaktbereich vermindert werden und es kommt zu einer zusätzlichen Fixierung des Flachbandkabels im Kontaktbereich, sodaß die eigentliche Kontaktfläche mechanisch nach beiden Seiten abgeschirmt ist.

Die Bewegung des Bauteiles, der die Spitze bzw. Schneide und bevorzugt auch die Kontakte und die Riffelung trägt, kann auf an sich bekannte Weise durch Nocken, durch Keile oder durch Zuklappen des Gehäuses erfolgen und ist für den Fachmann auf dem Gebiete des Steckerbaues kein Problem.

Durch die erfindungsgemäßen Maßnahmen wird es auch möglich, alle Leiterbahnen oder zumindest eine größere Anzahl von Leiterbahnen eines Flachbandkabels simultan zu kontaktieren, wodurch einerseits die damit verknüpfte Arbeitszeit verkürzt wird, anderseits Fehler vermieden werden können, da das richtige Einbringen des Endes des Flachbandkabels in den Stecker umso besser kontrolliert und überprüft werden kann, je voluminöser und mechanisch stabiler dieses Ende ist.

Die Erfindung ermöglicht auch einen einfachen Übergang auf Rundkabel, da dazu nur die einzelnen Kontakte (Pins) des Steckers mit entsprechenden Litzen eines Rundkabels verbunden sein müssen. Es kann selbstverständlich der Stecker auch direkt Teil einer Platine oder eines Stromverbrauchers sein.

Die Erfindung wird im folgenden an Hand der Zeichnung näher erläutert. Dabei zeigt
die Fig. 1 einen abisolierten Flachbandleiter in Seitenansicht,
die Fig. 2 in Draufsicht und
die Fig. 3 eine schematische Darstellung eines erfindungsgemäßen Steckers für ein abisoliertes Flachbandkabel.

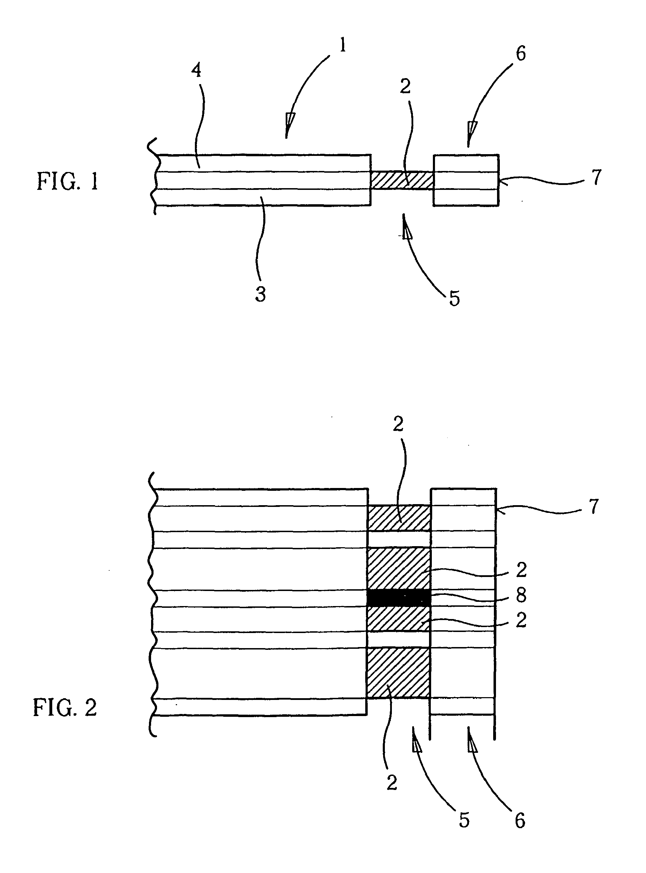

In den Fig. 1 und 2 ist ein abisoliertes Flachbandkabel dargestellt. In seiner Gesamtheit ist der Flachbandleiter mit 1 bezeichnet. Er besteht aus mehreren Leiterbahnen, auch Rechteckleiter genannt, die im gezeigten Ausführungsbeispiel unterschiedliche Breite (Fig. 2), aber gleiche Dicke besitzen. Diese Leiterbahnen 2 sind auf einer Trägerfolie 3 im Abstand voneinander angeordnet, sodaß sie voneinander elektrisch isoliert sind. Die Isolierung wird durch eine Abdeckfolie 4 vervollständigt, die mittels Klebstoff und/oder Erwärmen oder andere Verbindungstechniken auf die Trägerfolie 3 und die Leiterbahnen 2 auflaminiert worden sind. Wie bereits ausgeführt, ist ein extrudiertes Flachbandkabel für die Erfindung völlig analog zu behandeln.

Nun wird im Abstand vom Ende 7 des Flachleiters sowohl die Trägerfolie 3 als auch die Abdeckfolie 4 in ihrer Gesamtheit (gegebenenfalls das gesamte isolierende Extrudat) entfernt, sodaß nur die unterschiedlich breit dargestellten Rechteckleiter 2, das dadurch gebildete Endstück, den Isoliersteg 6, nachfolgend auch Isolierbereich oder Isolierabschnitt genannt, mit dem eigentlichen Flachleiter 1 verbinden. Dieses nur aus den Leiterbahnen 2 bestehende Stück wird auch als Abisolierung 5 oder Kontaktfenster bezeichnet.

In den Figuren ist die Dicke der Folien 3 und 4 im Vergleich zur Stärke der Leiterbahnen 2 stark übertrieben dargestellt, doch auch unter Berücksichtigung dieser Verdeutlichung der Verhältnisse wird klar, daß die mechanische Stabilität des Isolierbereiches 5 im Vergleich zu einem gemäß dem Stand der Technik am Ende 7 abisolierten Flachbandkabel 1 wesentlich vergrößert ist. Insbesondere das Ergreifen und Handhaben der abisolierten Leiterbahnen (Rechteckleiter 2) wird durch den Isoliersteg 6 deutlich erleichtert und das bei einem gleichzeitig verbesserten Schutz gegen jedwede Beschädigung während des Transportes eines bereits abisolierten Flachbandleiters.

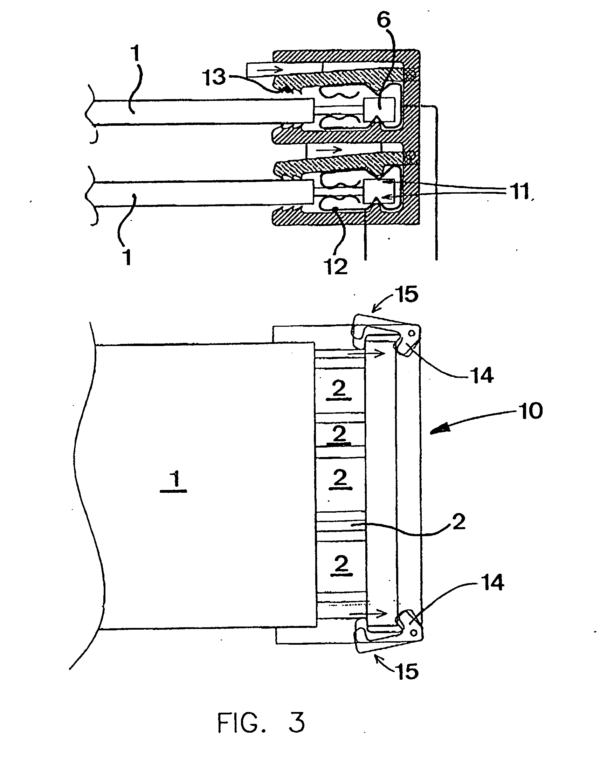

Die Abisolierung von Flachbandleitern ermöglicht auch eine wesentlich verbesserte Kontaktierung dieser Flachbandleiter bzw. von deren Leiterbahnen, beispielsweise durch den in Fig. 3 rein schematisch dargestellten Stecker 10. Dieser Stecker weist Einzelkontakte auf, die äquidistanten Abstand voneinander haben, wie der schematische Schnitt an oberster Stelle der Fig. 3 zeigt. Je nach Breite der zu kontaktierenden Leiterbahnen werden zwei oder auch mehrere dieser Einzelkontakte elektrisch miteinander verbunden und sind so in der Lage gemeinsam auch große Stromstärken zu übertragen, ohne daß für jede Stromstärkenstufe ein eigener Stecker oder ein eigener Kontakt geschaffen und verwendet werden müßte.

Wie aus der oberen Figur der Fig. 3 hervorgeht, ist im gezeigten Ausführungsbeispiel ein in zwei Ebenen Flachbandleiter 1 kontaktierender Stecker 10 dargestellt, selbstverständlich ist es auch möglich, einen nur in einer Ebene kontaktierenden Stecker zu verwenden bzw. zu schaffen.

Ein Stecker 10 weist in seinem (vom Flachbandkabel 1 aus gesehen) hintersten Bereich eine Spitze oder eine Schneide 11 auf, die beim Schließen des Steckers (darunter wird prinzipiell jede Form des Erfassens des Flachbandkabels und des Kontaktierens verstanden, ob dies nun tatsächlich durch Schließen eines mehrteiligen Gehäuses oder, wie im dargestellten Ausführungsbeispiel durch Einschieben von Haltekeilen oder durch Noppen oder wie auch immer erfolgt) durch die Trägerfolie und Abdeckfolie (die gesamte Dicke des Extrudates) hindurch, bis zur eigentlichen Leiterbahn (Rechteckleiter 2) vordringen, um diese Leiterbahn plastisch zu deformieren, sodaß mechanische Zugkräfte durch diese Spitzen oder Schneiden 11 direkt auf die metallischen Bauteile des Flachbandkabels übertragen werden.
Im gezeigten Ausführungsbeispiel sind diese Spitzen bzw. Schneiden 11 vom Steckerkontakt 12 überzogen und tragen daher auch zur Kontaktierung bei, was aber nicht notwendig ist. Im gezeigten Ausführungsbeispiel ist diese Variante aber deshalb vorteilhaft, weil durch das Schließen des Steckers 10 und die bügelartige Ausbildung des Steckerkontaktes 12 samt seiner Fixierung im Bereich des Isoliersteges 6 des Flachbandkabels 1 beim Schließen des Steckers zu einer Bewegung der Kontaktflächen des Steckerkontaktes 12 an der Oberfläche der Rechteckleiter 2 kommt und durch diese Bewegung eventuell an den Rechteckleitern anhaftender Schmutz entfernt wird, sodaß zuverlässig eine Metall-Metall-Kontaktierung sichergestellt wird.
Der erfindungsgemäße Stecker, wie er in Fig. 3 dargestellt ist, weist weiters an seiner äußersten, d.h. dem Flachbandkabel 1 zunächst liegenden Seite an seinen aus Kunststoff oder anderem elektrisch nicht leitenden Material bestehenden Bauteilen, die im Zuge des Schließens des Steckers einander angenähert werden, Leisten, Rippen, Zacken oder eine Riffelung 13, auf. Diese Elemente kontaktieren die Folien 3, 4 (Fig. 1) des Flachbandkabels 1 und dringen leicht in dessen Oberfläche ein. So sorgen sie einerseits für einen bestmöglichen Abschluß des Kontaktbereiches vor Umwelteinflüssen, anderseits für eine Zugübertragung auch auf die Kunststoffteile des Flachbandkabels 1.

In einer besonderen Ausgestaltung, die der unteren Darstellung der Fig. 3 zu entnehmen ist, ist zu sehen, daß das Gehäuse des Steckers 10 seitlich Haken aufweist, die beim Einschieben des Halte- und Isolierabschnitt 6 in den Stecker 10 durch das Anstoßen auf Vorsprünge der Haken 14, diese so verdrehen, daß die eigentlichen Hakenenden hinter (in Einschubrichtung gesehen) den Isolierabschnitt 6 gelangen und so diesen Abschnitt zusätzlich zu all den anderen Maßnahmen am Herausziehen hindern. In einer nicht dargestellten Ausführungsform wird das Schließen des Steckers 10 erst nach vollständigem Einschwenken der Haken 14 in Richtung der Pfeile 15 möglich. Dies kann beispielsweise durch Vorsprünge, Stifte, Leisten, Nocken od.dgl. geschehen, die erst mit erfolgtem vollständigem Einschwenken der Haken 15 in Bereiche zu liegen kommen, in denen das Gehäuse des Steckers 10 entsprechende Ausnehmungen aufweist, die das Schließen gestatten.

Die Erfindung ist nicht auf das dargestellte Ausführungsbeispiel beschränkt, sondern kann verschiedentlich abgewandelt und verändert werden. So ist es nicht notwendig, daß die Leiterbahnen unterschiedliche Breite besitzen oder auch, daß sie gleiche Höhe besitzen, wenn dies auch wegen der vereinfachten Kontaktierung in den erfindungsgemäßen Stekkern bevorzugt wird. Es ist selbstverständlich möglich, daß mehr oder weniger Leiterbahnen als dargestellt vorgesehen werden und es ist selbstverständlich möglich, daß die gesamten Dimensionen anders als dargestellt sind. Auch ist es möglich, mehrere Träger- und/oder Abdeckfolien (bzw. mehrere Schichten von Extrudat) vorzusehen, wenn, aus welchen Gründen auch immer, besondere mechanische Stabilität gewünscht ist.

Wesentlich ist, daß unmittelbar am Ende 7 des Flachbandleiters ein Bereich über zumindest den Großteil seiner Breite besteht, in dem zumindest einige der Rechteckleiter 2 sowohl an ihrer Oberseite als auch an ihrer Unterseite von zusammenhängenden Folien bedeckt werden (bzw. von einer gemeinsamen Extrudatmasse umgeben werden) und daß im Abstand vom Ende 7 ein Bereich besteht, in dem diese Rechteckleiter 2 an der Ober- und/oder Unterseite frei von jeder Folie sind.

Der erfindungsgemäße Stecker kann selbstverständlich vielfach variiert werden, so ist es beispielsweise möglich, zur Verbindung von Flachkabel zu Flachkabel, beispielsweise zu Reparaturzwecken, eine Art "Doppelstecker" vorzusehen, der beidseits mit erfindungsgemäßen Kontakten und gegebenenfalls auch mit entsprechenden Haken für beide Flachkabel versehen ist. Selbstverständlich sind auch Übergänge auf Rundkabel oder direkt auf Platinen ohne weiteres möglich.

## Patentansprüche

1. Stecker zur Kontaktierung eines Flachbandkabels (1), das voneinander elektrisch isolierte, d.h. mit Abstand zueinander angeordnete, Rechteckleiter (2) aufweist, die von einer auflaminierten oder aufextrudierten, elektrisch isolierenden Hülle (34) umgeben sind, wobei das Flachbandkabel in einem Bereich, der in einem Abstand von einem Ende (7) des Flachbandkabels (1) liegt, mit einer zumindest einseitigen Abisolierung (5) des Flachbandkabels (1) versehen ist und so einen Isoliersteg (6) an dessen Ende beläßt, dessen Erstreckung in Richtung der Leiterbahnen bevorzugt etwa 1 bis 10 mm, besonders bevorzugt 2 bis 4 mm beträgt, **dadurch gekennzeichnet, daß** der Stecker (10) im Bereich der Abisolierung (5) jedes zu kontaktierenden Rechteckleiters (2) zur elektrischen Kontaktierung zumindest einen Steckerkontakt (12) aufweist und im Bereich des Isoliersteges (6) jedes zu kontaktierenden Rechteckleiters (2) zumindest eine Spitze und/oder zumindest eine im wesentlichen quer zum Rechteckleiter (2) verlaufende Schneide (11) aufweist, die im Zuge der Kontaktierung des Flachbandkabels (1) eine Bewegung zum Rechteckleiter (2) hin vollführt, sodaß die Spitze und/oder Schneide (11) den Rechteckleiter (2) durch die auf dieser Seite abdeckende, elektrisch isolierende thülle hindurch mechanisch kontaktiert und plastisch deformiert.

2. Stecker nach Anspruch 1, **dadurch gekennzeichnet, daß** zumindest eine Spitze bzw. Schneide (11) vom Steckerkontakt (12) überzogen ist.

3. Stecker nach Anspruch 2, **dadurch gekennzeichnet, daß** der Steckerkontakt (12) bügelartig ausgebildet und im Bereich des Isoliersteges (6) des Flachbandkabels (1) fixiert ist, sodass es beim Schließen des Steckers (10) zu einer Bewegung der Kontaktflächen des Steckerkontaktes (12) an der Oberfläche der Rechteckleiter (2) kommt.

4. Stecker nach einem der Ansprüche 1 bis 3, **dadurch gekennzeichnet, daß** er ein Gehäuse besitzt, das seitlich Haken (15) aufweist, die beim Einschieben des Isoliersteges (6) in den Stecker (10) durch Anschläge (14) so verdreht werden, daß die Hakenenden, in Einschubrichtung gesehen, hinter den Isoliersteg (6) gelangen.

5. Stecker nach Anspruch 4, **dadurch gekennzeichnet, daß** Vorsprünge, Stifte, Leisten, oder Nocken vorgesehen sind, die erst mit erfolgtem vollständigem Einschwenken der Haken (15) in eine Position gelangen, in der das Gehäuse des Steckers (10) korrespondierende Ausnehmungen aufweist, die das Schließen gestatten.

6. Stecker nach Anspruch 1, **dadurch gekennzeichnet, daß** die Bauteile des Steckers, die die Spitzen bzw. die Schneiden (11) und den Steckerkontakt (12) tragen, an ihrem-dem Flachband zugekehrten Ende Leisten, Rippen, Zacken oder eine quer zur Richtung der Rechteckleiter (2) verlaufende Riffelung (13) aufweisen, die das Flachbandkabel (1) ihm Bereich jenseits der Abisolierung (5) kontaktiert.

## Claims

1. Plug for making contact with a flat ribbon cable (1), which has rectangular conductors (2), which are electrically insulated from one another, i.e. are arranged at a distance from one another, and are surrounded by an electrically insulating sleeve (34) which has been laminated or extruded on, the flat ribbon cable being provided with a section (5), from which the insulation has been stripped on at least one side, of the flat ribbon cable (1) in a region which is at a distance from one end (7) of the flat ribbon cable (1) and thus leaving an insulating web (6) at its end whose extent is preferably approximately 1 to 10 mm, particularly preferably 2 to 4 mm, in the direction of the conductor tracks, **characterized in that** the plug (10) has at least one plug contact (12) for electrical contact-making purposes in the region of the section (5), from which the insulation has been stripped, of each rectangular conductor (2) with which contact is to be made and, in the region of the insulating web (6) of each rectangular conductor (2) with which contact is to be made, has at least one tip and/or at least one blade (11), which extends essentially transversely with respect to the rectangular conductor (2) and performs a movement towards the rectangular conductor (2) whilst contact is made with the flat ribbon cable (1), with the result that the tip and/or blade (11) makes mechanical contact with and plastically deforms the rectangular conductor (2) through the electrically insulating sleeve covering this side.

2. Plug according to Claim 1, **characterized in that** at least one tip or blade (11) is covered by the plug contact (12).

3. Plug according to Claim 2, **characterized in that** the plug contact (12) is in the form of a clip and is fixed in the region of the insulating web (6) of the flat ribbon cable (1) such that, when the plug (10) is closed, a movement of the contact faces of the plug contact (12) on the surface of the rectangular conductor (2) results.

4. Plug according to one of Claims 1 to 3, **characterized in that** it has a housing which has hooks (15) at the side which, when the insulating web (6) is inserted into the plug (10), is rotated by means of stops (14) such that the hook ends, when viewed in the insertion direction, reach behind the insulating web (6).

5. Plug according to Claim 4, **characterized in that** projections, pins, strips or cams are provided which only reach a position in which the housing of the plug (10) has corresponding cutouts allowing for it to be closed when the hooks (15) have been completely pivoted in.

6. Plug according to Claim 1, **characterized in that** the components of the plug which bear the tips or the blades (11) and the plug contact (12) have, on their end facing the flat ribbon, strips, ribs, zigzags or a corrugated section (13), which extends transversely with respect to the direction of the rectangular conductor (2) and makes contact with the flat ribbon cable (1) in the region on the other side of the section (5) from which the insulation has been stripped.

## Revendications

1. Connecteur pour connecter un câble-ruban plat (1) qui comporte des conducteurs rectangulaires (2) isolés électriquement les uns des autres, c'est-à-dire disposés à distance les uns des autres, qui sont entourés d'une gaine électriquement isolante (3, 4) lamellée ou extrudée, le câble-ruban plat, dans une zone qui se trouve à une distance de l'extrémité (7) du câble-ruban plat (1), étant équipé d'au moins un dénudement unilatéral (5) du câble-ruban plat (1) et laissant ainsi une tige d'isolation (6) à l'extrémité de celui-ci, dont la prolongation dans le sens des voies conductrices est de préférence environ 1 à 10 mm, en particulier de préférence 2 à 4 mm, **caractérisé en ce que** le connecteur (10) comporte au moins un contact de connecteur (12) dans la zone du dénudement (5) de chaque conducteur rectangulaire (2) à connecter pour la connexion électrique et dans la zone de la tige isolante (6) de chaque conducteur rectangulaire (2) à connecter au moins une pointe et/ou au moins une arête (11) passant essentiellement transversalement par rapport au conducteur rectangulaire (2), qui au cours de la connexion du câble-ruban plat (1) fait un mouvement vers le conducteur rectangulaire (2) de sorte que la pointe et/ou l'arête (11) connecte mécaniquement et déforme de manière souple le conducteur rectangulaire (2) à travers la gaine électriquement isolante la recouvrant de ce côté.

2. Connecteur selon la revendication 1, **caractérisé en ce qu'**au moins une pointe ou une arête (11) est équipée d'un contact de connecteur (12).

3. Connecteur selon revendication 2, **caractérisé en ce que** le contact de connecteur (12) est configuré sous forme d'un U et est fixé dans la zone de la tige isolante (6) du câble-ruban plat (1) de sorte qu'un mouvement des surfaces de contact du contact du connecteur (12) se produise à la fermeture du connecteur (10) à la surface du conducteur rectangulaire (2).

4. Connecteur selon l'une des revendications 1 à 3, **caractérisé en ce qu'**il possède un boîtier qui comporte latéralement des crochets (15), qui sont tournés lors de la rétraction de la tige isolante (6) dans le connecteur (10) par des butées (14) de telle manière que les extrémités des crochets, vues dans le sens d'insertion, arrivent derrière la tige isolante (6).

5. Connecteur selon la revendication 4, **caractérisé en ce que** des protubérances, broches, baguettes ou taquets sont prévus, qui parviennent d'abord avec un pivotement complet des crochets (15) dans une position dans laquelle le boîtier du connecteur (10) comporte des évidements correspondants qui permettent la fermeture.

6. Connecteur selon la revendication 1, **caractérisé en ce que** les composants du connecteur, qui portent les pointes ou les arêtes (11) et le contact de connecteur (12) comportent à leur extrémité tournée vers le ruban plat, des baguette, nervures, dents ou des stries (13) passant transversalement dans le sens d'un conducteur rectangulaire (2), qui connecte le câble-ruban plat (1) dans la zone de l'autre côté du dénudement (5).
